Europäisches Patentamt

(19) European Patent Office  (11) Numéro de publication: **0 186 533**

Office européen des brevets  **B1**

(12) **FASCICULE DE BREVET EUROPEEN**

(45) Date de publication du fascicule du brevet:
24.05.89

(51) Int. Cl.⁴: **G 11 C 11/40, H 01 L 29/64,
H 03 K 3/356**

(21) Numéro de dépôt: **85402179.7**

(22) Date de dépôt: **12.11.85**

(54) Elément de mémoire dynamique et son utilisation dans une bascule maître-esclave et dans des circuits séquentiels programmables.

(30) Priorité: **16.11.84 FR 8417557**

(43) Date de publication de la demande:
**02.07.86 Bulletin 86/27**

(45) Mention de la délivrance du brevet:
**24.05.89 Bulletin 89/21**

(84) Etats contractants désignés:
**DE GB NL**

(73) Titulaire: **THOMSON-CSF, 51, Esplanade du Général de Gaulle, F-92800 Puteaux (FR)**

(72) Inventeur: **Pham, Ngu Tung, THOMSON-CSF
SCPI 173, bld Haussmann, F-75379 Paris Cedex 08 (FR)**

(74) Mandataire: **Taboureau, James et al, THOMSON-CSF
SCPI, F-92045 PARIS LA DEFENSE CEDEX 67 (FR)**

(56) Documents cités:
US-A- 3 395 291

1981 IEEE MTT-S INTERNATIONAL MICROWAVE
SYMPOSIUM DIGEST, 1981, pages 362-364, IEEE, New
York, US; R.E. LUNDGREN et al.: "A high-speed
monolithic GaAs 10/11 counter"
IDEM
MICROELECTRONICS JOURNAL, vol. 8, no. 4, juin 1978,
pages 5-9, Mackintosh Publications Ltd., Luton, GB;
H.L. HARTNAGEL: "New gallium arsenide oxidation
technique for microwave integrated circuits"
IDEM
PATENTS ABSTRACTS OF JAPAN, vol. 7, no. 194 (E 195)
[1339], 24 août 1983, page 87 E 195; & JP - A - 58 95 870
(MITSUBISHI DENKI K.K.) 07.06.1983
PATENTS ABSTRACTS OF JAPAN, vol. 4, no. 66 (P-11)

(56) Documents cités: (suite)
[548], 11 mai 1980, page 94 P 11; & JP - A - 55 34 348
(FUJITSU K.K.) 10.03.1980
IEE PROCEEDINGS, vol. 127, partie I, no. 2, avril 1980,
pages 98-99; J. MUN et al.: "GaAs diode/f.e.t. logic
circuits for high-speed-frequency-divider applications"

## Description

La présente invention concerne un élément de mémoire dynamique, constitué par un transistor à effet de champ muni de deux grilles, dont l'une sert à l'alimentation du transistor, dont le drain est isolé et dont la source est à la masse. Le transistor de l'élément de mémoire selon l'invention est du type normalement bloqué, connu sous l'appellation anglaise «normally-off», et à tension de seuil positive.

L'invention concerne également les circuits qui mettent en œuvre cet élément mémoire, notamment une bascule maitre-esclave dynamique et des diviseurs, à rang fixe ou programmable.

Bien que l'invention soit surtout orientée vers les transistors rapides, réalisés en matériaux du groupe III-V, tels que GaAs ou d'autres composés ternaires ou quaternaires plus complexes, elle s'applique également aux transistors à effet de champ en silicium.

L'élément de mémoire selon l'invention est constitué par un unique transistor à effet de champ bigrille. La source de ce transistor est montée à la masse, et le drain, qui constitue la sortie du point mémoire, est isolé, c'est-à-dire qu'en pratique il est relié à une charge capacitive telle que la grille d'un autre transistor. La première grille, celle qui se trouve sur la pastille du transistor à proximité de la source, constitue l'entrée du point mémoire. La seconde grille, celle qui se trouve à proximité du drain, est reliée à une horloge dont les signaux, des 0 et des 1 logiques, constituent en outre l'alimentation du transistor. Les grilles sont des grilles Schottky qui présentent donc un effet de diode dans un sens et un effet de fuite de courant. Etant donné que ce transistor n'est pas alimenté, comme cela est classique, par son drain, mais qu'il l'est par sa seconde grille, des séquences appropriées de signaux logiques sur les deux grilles permettent de charger le transistor puis de stocker la charge, puisque le drain est isolé, et enfin de restituer cette charge sous forme d'une impulsion dans un circuit extérieur. Ce transistor à drain isolé constitue donc un point mémoire.

De façon plus précise, l'invention consiste en un élément de mémoire dynamique caractérisé en ce qu'il est constitué par un transistor à effet de champ de type normalement bloqué (tension de seuil positive), dont:
- la source est reliée à la masse,
- le drain, isolé, constitue la sortie du point mémoire relié à une charge capacitive C,
- la première grille de type Schottky et voisine de la source du transistor constitue l'entrée de l'élément de mémoire, ou entrée d'écriture,
- la deuxième grille, de type Schottky et voisine du drain du transistor, est reliée à une horloge, dont le signal logique, 0 ou 1, commande le fonctionnement du transistor et simultanément sert d'alimentation à cet élément de mémoire.

L'invention sera mieux comprise par la description suivante du point mémoire, qui est à la base des exemples d'application cités, s'appuyant sur les figures jointes en annexes et qui représentent:
- figure 1: schéma du point mémoire dynamique selon l'invention,
- figure 2: schéma d'une bascule maitre-esclave dynamique selon l'invention,
- figure 3: schéma symbolique de la bascule précédente,
- figure 4: schéma symbolique d'un diviseur par 2, selon l'invention,
- figure 5: schéma symbolique d'un diviseur programmable selon l'invention.

Dans les circuits logiques séquentiels, les informations, des 0 et des 1 logiques, circulent de proche en proche sans jamais s'arrêter. Pour ce type de circuits, il n'est pas nécessaire d'utiliser des bascules statiquement stables, qui sont à la fois peu rapides, encombrantes du point de vue de l'intégration et qui consomment beaucoup. Les bascules dynamiques ont l'avantage d'être beaucoup plus rapides, plus simples à réaliser et de faible consommation. Elles sont mieux adaptées aux circuits ultra-rapides à très haute intégration.

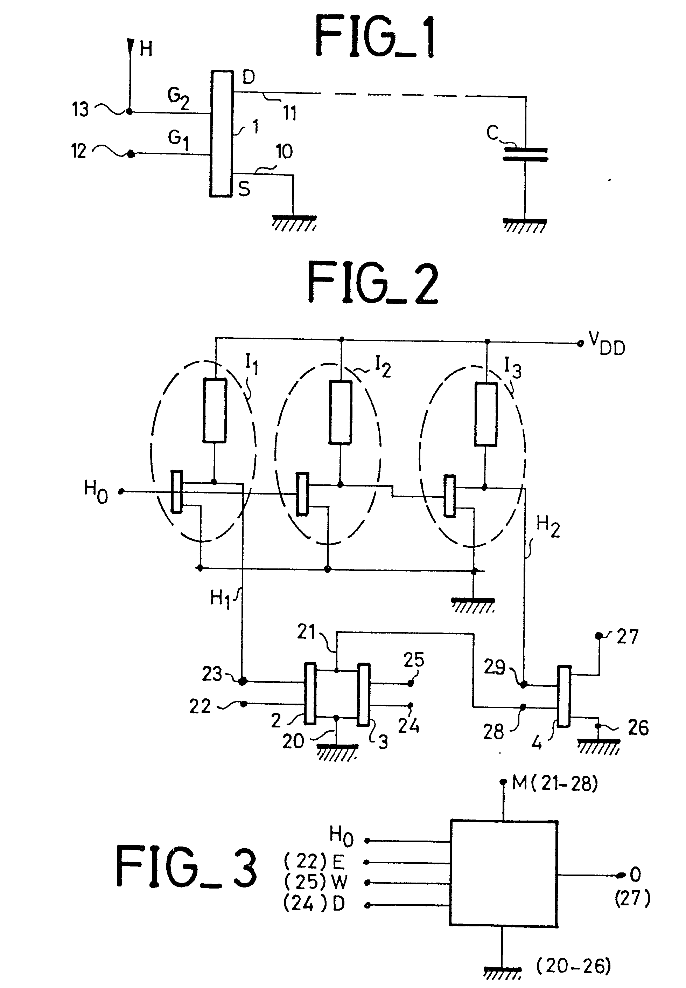

La figure 1 représente le schéma du point mémoire dynamique selon l'invention: ce point mémoire est constitué par un unique transistor qui se comporte en bascule dynamique.

C'est un transistor à effet de champ 1, muni de deux grilles Schottky. Sa source 10 est reliée à la masse du circuit. Son drain 11, qui constitue la sortie de la bascule, est relié d'impédance élevée, symbolisée par une capacité C. Cette capacité C peut être par exemple la capacité présentée par la grille d'un autre transistor à effet de champ commandé par la sortie de la bascule. Sa première grille 12, celle qui est voisine de la source 10 sur la pastille du transistor, constitue l'entrée de l'information dans la bascule. Sa seconde grille 13, voisine du drain 11, est reliée à un signal d'horloge H, fourni par une horloge extérieure à la bascule.

Il faut remarquer que ce transistor n'est pas alimenté par une source de tension ou de courant qui serait, comme cela est le cas le plus fréquent, connectée au drain 11. C'est le signal d'horloge H qui sert d'alimentation au transistor, et tout le fonctionnement de la bascule est basé sur la bonne isolation du drain 11.

Les séquences de fonctionnement de la bascule sont données par le tableau de séquence:

| Séquence | le grille 12 entrée | 2e grille 13 horloge | drain 11 sortie |
|---|---|---|---|
| 1 | 1 | 1 | 0 |
| 2 | 1 | 0 | 0 |
| 3 | 0 | 0 | 0 |
| 4 | 0 | 1 | 1 |
| 5 | 0 | 0 | 1 |
| 6 | 1 | 0 | 1 |

qui se lit de la façon suivante:

Séquence 1: les deux grilles sont sous tension, le transistor est passant, la sortie 11 mise à la masse commute au niveau 0.

Séquence 2: la première grille 12 est sous tension mais la deuxième grille 13 est bloquante, parce que le signal d'horloge H est au niveau bas, donc le transistor est bloquant. Le transistor reste dans l'état précédent parce qu'il est isolé de la masse.

Séquence 3: les deux grilles sont maintenant bloquantes, le transistor est bloquant et reste toujours dans l'état précédent, c'est-a-dire à l'état 0.

Séquence 4: le transistor est bloqué par sa première grille 12, mais alimenté par l'horloge H à travers la deuxième grille 13: le drain 11 est entrainé au niveau 1 par le signal d'horloge, parce que la métallisation Schottky de la grille 13 constituant une diode dans le sens grille-drain fait passer le courant nécessaire pour la charge de C.

Séquence 5: les deux grilles sont bloquantes, le transistor est bloquant mais, puisque le drain est isolé, il reste chargé, dans l'état précédent. Une décharge très lente s'opère cependant, par les courants de fuite dans les différentes jonctions du transistor, mais, aux vitesses de fonctionnement de la bascule, cette décharge n'a pas à être prise en compte.

Séquence 6: l'horloge H est toujours à l'état bas, donc la deuxième grille 13 bloque le transistor. Une nouvelle information, un 1 logique, arrive sur la première grille 12, mais comme le transistor est bloqué, il reste chargé dans l'état précédent. Une décharge lente s'opère encore, mais sans influence sur le fonctionnement de cette mémoire dynamique.

A la séquence suivante, le transistor revient dans l'état de la première séquence.

L'effet de mémoire de cette bascule repose sur le bon isolement du drain, avec charge à travers la diode Schottky de la deuxième grille 13, lorsque le transistor est bloqué par la première grille 12, et décharge à travers la source, dans la seule séquence où le transistor est passant. Pour cette raison, la bascule selon l'invention requiert un transistor à tension de seuil positive, pour assurer un blocage efficace.

Les circuits dont la description suit constituent des exemples d'application de la bascule ou point mémoire de l'invention.

La figure 2 est un premier cas d'application, qui est une bascule maitre-esclave dynamique.

La bascule maitre est composée de deux transistors bigrilles 2 et 3, montés en parallèle: les deux sources 20 des deux transistors sont reliées à la masse, et les deux drains 21, réunis, constituent la sortie de cette bascule maitre.

La première grille 22 du transistor 2 constitue l'entrée de la bascule, et la deuxième grille 23 de ce même transistor est reliée à une horloge qui lui fournit un signal $H_1$.

La première grille 24 du transistor 3 constitue l'entrée de remise à 1 ou à 0 (SET-RESET) et la deuxième grille 25 de ce même transistor correspond au mode d'écriture, qui sera explicité ultérieurement.

Bien entendu, les fonctions des deux transistors 2 et 3 sont interchangeables.

La bascule esclave est constituée d'un unique transistor bigrille 4, et dont la source 26 est reliée à la masse, le drain 27 forme la sortie de la bascule maitre-esclave, la première grille 28 reçoit les signaux issus de la sortie 21 de la bascule maitre 2+3, et la deuxième grille 29 est reliée à une horloge qui lui fournit un signal $H_2$, toujours en opposition de phase par rapport au signal $H_1$.

Pour l'ensemble des trois transistors 2, 3 et 4, on a gardé la même convention que pour la figure 1: la première grille (22, 24, 28) est celle qui est voisine de la source, la deuxième grille (23, 25, 29) est celle qui est voisine du drain, pour un transistor considéré.

Chacun des trois transistors 2, 3 et 4 de cette bascule maitre-esclave est conforme au transistor formant une bascule dynamique selon l'invention et décrit en figure 1.

Les signaux d'horloge $H_1$ et $H_2$, en opposition de phase, qui commandent la bascule maitre-esclave, sont générés, par trois inverseurs à couplage direct de type DCFL, ou «Direct Coupled FET Logic». Ces inverseurs sont les plus simples à réaliser, donc les plus aptes à l'intégration à grande échelle: chacun comporte un transistor à effet de champ dont la source est reliée à la masse et dont le drain est alimenté à partir d'une tension $V_{DD}$ à travers une résistance de charge. La grille constitue l'entrée de l'inverseur, dont le drain est la sortie. Ce type d'inverseur se réalise avec des transistors normalement bloqués, ou normally-off, c'est-à-dire le même genre de transistors que ceux utilisés dans l'invention, ce qui favorise l'intégration.

Les trois inverseurs $I_1$, $I_2$ et $I_3$ sont montés en série/parallèle, c'est-à-dire que les deux premiers $I_1$ et $I_2$ sont attaqués en parallèle par un même signal d'horloge-mère $H_0$. La sortie de l'inverseur $I_1$, prélevée entre le drain et la charge d'alimentation, constitue le signal d'horloge $H_1$ qui commande le transistor 2 de la bascule maitre. Les deux derniers inverseurs $I_2$ et $I_3$, sont montés en série: la sortie de l'inverseur $I_2$ attaque l'inverseur $I_3$, dont la sortie constitue le signal d'horloge $H_2$ qui commande le transistor 4 de la bascule exclave.

Les deux signaux d'horloge $H_1$ et $H_2$ sont toujours en opposition de phase. En effet, si $H_0$ est à l'état bas, 0 logique, la sortie de $I_1$ est à l'état haut: $H_1$ = 1 logique, mais la sortie de $I_2$, monté en parallèle, est aussi à l'état haut, donc l'entrée de $I_3$ à l'état haut, et la sortie de $I_3$ à l'état bas: $H_2$ = 0 logique. Par ailleurs, afin de rendre le retard de $H_2$ sur $H_1$ le plus faible possible, l'inverseur $I_2$ a une taille au moins deux fois plus grande que celle des inverseurs $I_1$ et $I_3$, ce qui diminue le temps de basculement.

En ce qui concerne le transistor 3 de la bascule maitre, l'entrée sur la première grille 24 sert pour les opérations entrées parallèles (en 22 et 24) – sorties séries (en 21) en fonction du mode d'écriture imposé par la deuxième grille 25.

Dans un premier exemple d'utilisation de cette bascule maitre-esclave, l'entrée du mode d'écriture 25 est mise à 0. La bascule maitre est dans ce cas indépendante de l'entrée 24, et l'ensemble maitre-esclave fonctionne en registre à décalage, selon le tableau de séquences suivant:

| Séquence | Entrée 22 | Horloge $H_1$ 23 | Sortie 21 entrée 28 | Horloge $H_2$ 28 | Sortie 27 |
|---|---|---|---|---|---|
| 1 | 1 | 1 | 0 | 0 | X |
| 2 | 1 | 0 | 0 | 1 | 1 |
| 3 | 0 | 0 | 0 | 1 | 1 |
| 4 | 0 | 1 | 1 | 0 | 1 |
| 5 | 0 | 0 | 1 | 1 | 0 |
| 6 | 1 | 0 | 1 | 1 | 0 |
| 7 | 1 | 1 | 0 | 0 | 0 |

Le signe X en première séquence signifie que la sortie 27 de la bascule maitre-esclave conserve son état antérieur, qui était soit 1 soit 0.

La séquence 7 ramène à la séquence 1, à l'état de la sortie 27 près, qui était indéterminé.

Le fonctionnement de ce registre à décalage se comprend aisément si on décompose ce tableau de séquences en deux. Un premier tableau de séquences regroupent les colonnes 22, 23 et 21, et correspond au tableau de séquences qui a été exposé à l'occasion de la bascule dynamique de la figure 1: c'est le tableau de séquences du transistor 2 considéré isolément. Un second tableau de séquences regroupe les colonnes 28, 29 et 27, la colonne d'entrée 28 étant la même que la colonne de sortie 21: c'est le tableau de séquences du transistor 4 considéré isolément. Ces deux tableaux de séquences sont liés par une condition: l'état de l'horloge $H_2$ est toujours en opposition de phase avec l'état de l'horloge $H_1$.

Les opérations, au cours de chaque séquence, sont:

– séquence 1: inscription d'un niveau 1 au maitre,

– séquence 2: verrouillage et transfert du 1 à l'esclave,

– séquence 3: verrouillage et changement à 0 au maitre,

– séquence 4: inscription d'un niveau 0 au maitre,

– séquence 5: verrouillage et transfert du 0 à l'esclave,

– séquence 6: verrouillage et changement à 1 au maitre,

– séquence 7: retour à la séquence 1.

Dans ce premier exemple d'application, seul le transistor 2 de la bascule maitre est utilisé: l'entrée 22 sur la première grille sert au fonctionnement entrées séries – sorties séries.

Dans le cas du fonctionnement entrées parallèles – sorties séries, les entrées en parallèle se font sur les premières grilles 22 et 24 des deux transistors 2 et 3 de la bascule maitre, et l'horloge $H_0$ est bloquée sur un niveau haut 1 logique. En reliant l'entrée de mode d'écriture 25 à un niveau 1 logique, la bascule peut inscrire les valeurs entrées sur la première grille 24 du transistor 3.

Pour simplifier les figures des autres exemples d'application, ou conviendra d'adopter pour la bascule maitre-esclave et ses horloges de la figure 2 la représentation symbolique de la figure 3, dans laquelle:

– $H_0$ est l'entrée du signal d'horloge-mère,

– E est la première entrée 22 de la bascule maitre,

– W est l'entrée 25 de sélection de mode d'écriture,

– D est la deuxième entrée 24 de la bascule maitre,

– M est la sortie intermédiaire 21–28 ou sortie de la bascule maitre,

– O est la sortie 27, ou sortie de la bascule esclave.

Chaque entrée en E ressort en O avec un décalage d'une période T de l'horloge $H_0$ parce que $H_1$ et $H_2$ sont déphasés. L'état de la sortie O reste indépendant de l'état de l'entrée E tant que l'horloge n'avance pas.

L'une des applications les plus courantes des registres à décalage sont les diviseurs de fréquence, dont deux exemples seront maintenant décrits.

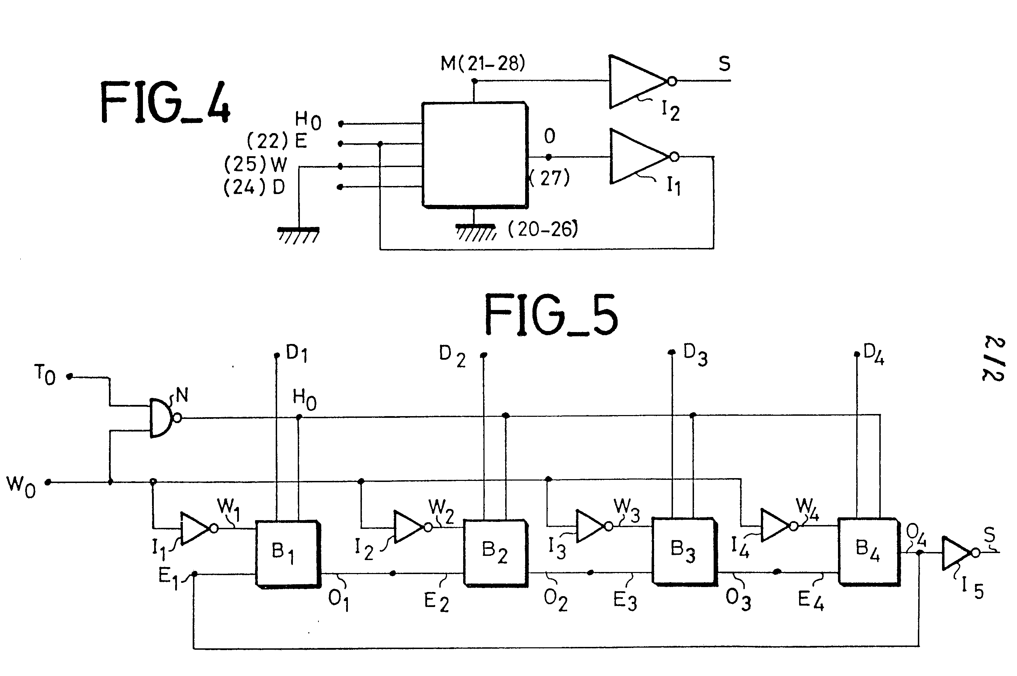

La figure 4 représente un diviseur de fréquence par 2, utilisant le registre à décalage de l'invention, symbolisé en figure 3.

Ce diviseur de fréquence par 2 comporte un registre à décalage selon l'invention, dont la sortie O (drain 27 de la bascule esclave 4) est rebouclée sur l'entrée E (première grille 22 de la bascule maitre 2) par l'intermédiaire d'un inverseur $I_1$. Pour rester compatible avec la technologie utilisée pour le registre à décalage, l'inverseur $I_1$ est de type à couplage direct DCFL. Le signal de sortie S est prélevé sur la sortie intermédiaire M (21+28) au moyen d'un deuxième inverseur $I_2$, également de type DCFL, qui sert de tampon ou buffer Prélever le signal de sortie sur la sortie intermédiaire M permet d'équilibrer les temps de commutation: en effet, les temps de basculement $t_{phl}$ et $t_{plh}$ des bascules maitres et esclaves sont proportionnels aux capacités mises en jeu, donc au nombre de grilles de transistors.

Dans ce diviseur de fréquence, l'entrée de sélection de mode d'écriture W est mise au niveau 0, le diviseur est indépendant de l'entrée D: le transistor 3 de la bascule maitre n'intervient pas.

Ce diviseur par 2 fonctionne de la façon suivant: la sortie O (27) recopie le niveau, non inversé, de l'entrée E (22) chaque fois que le signal d'horloge $H_0$ est au niveau haut: $H_0=1$, c'est-à-dire $H_1=0$ avec un décalage d'un pas d'horloge $H_1$. Pendant ce temps, l'entrée E (22) du diviseur change de valeur, par l'intermédiaire de l'inverseur $I_1$ qui prélève le signal de sortie sur 0, l'inverse et le renvoie sur l'entrée E (22).

Par ailleurs, chaque fois que $H_0=1$, c'est-à-dire que $H_1=0$, le signal sur la sortie intermédiaire M (21–28) est inversé par rapport au signal sur la sortie 0 (27). Donc, après l'inverseur $I_2$, le signal sur la sortie S de l'inverseur $I_2$ a la même valeur que le signal sur la sortie 0 du registre à décalage.

Il y a donc permutation: lorsque la sortie change d'état, l'entrée prend sa valeur inversée, ce qui donne les séquences ci-dessous, chaque pas étant égal à une période d'horloge $H_0$:

| Pas | E | 0 | |
|---|---|---|---|
| 1 | 1 | 0 | |
| 2 | 0 | 1 | |
| 3 | 1 | 0 | . . .etc |

La fréquence de changement d'état du diviseur, sur la sortie 0 (27) ou, ce qui revient au même, sur la sortie S, est égale à 2 pas d'horloge, c'est donc un diviseur par 2.

Dans ce diviseur de fréquence, le transfert par demi-période d'horloge $H_0$ est celui d'une porte à un étage pour la bascule maitre, qui ne comporte que le transistor 2, et celui d'une porte à deux étages pour la bascule esclave, parce qu'elle comporte l'inverseur $I_1$. Pour cette raison, la sortie du diviseur est prélevée sur la sortie intermédiaire M (21–28) de la bascule maitre afin d'équilibrer les temps.

La fréquence maximale de ce diviseur de fréquence est approximativement:

$$F_{max} < \frac{1}{4t_0}$$

$t_0$ étant le temps de commutation d'un inverseur DCFL avec une sortance de 1. Avec les transistors de technologies TEGFET, on peut obtenir $T_0=15$ psec par inverseur et donc réaliser un diviseur de fréquence fonctionnant jusqu'à 15 GHz.

Le diviseur par 2 qui vient d'être décrit n'utilise pas le transistor 3 de la bascule maitre: l'entrée D (24) n'intervient pas, et l'entrée W (25) est maintenue à la masse, au 0 logique. En utilisant les entrées W et D, on peut réaliser des diviseurs de fréquence ou des générateurs d'impulsions programmables.

La figure 5 donne le schéma, sous forme symbolique, d'un circuit programmable. Celui-ci comporte 4 bascules maitre-esclave, selon le symbole de la figure 3, mais le nombre de bascules associées n'est nullement limitatif de l'invention, et pourrait être différent sans sortir du domaine de l'invention. Pour ce type de circuit programmable, il n'est pas nécessaire de faire ressortir la sortie intermédiaire M (21+28) pour chaque bascule maitre-esclave.

Le circuit programmable comporte 4 bascules maitre-esclave $B_1$, $B_2$, $B_3$, $B_4$ montées en série: la sortie $O_{n-1}$ de l'une attaque l'entrée $E_n$ de la suivante. Les entrées d'horloge $H_0$ sont toutes pilotées par un signal générateur d'horloge $T_0$, à travers une porte ET-NON N qui inhibe le signal $T_0$ lorsque l'on écrit avec le signal de sélection d'écriture $W_0$. Celui-ci est adressé, respectivement, aux quatre entrées $W_1$ à $W_4$ à travers quatre inverseurs $I_1$ à $I_4$, pour chaque bascule. La sortie $O_4$ de la dernière bascule $B_4$ est rebouclée sur l'entrée $E_1$ de la première bascules $B_1$.

Les entrées $D_1$ à $D_4$ peuvent inscrire des valeurs logiques 0 ou 1 dans les bascules $B_1$ à $B_4$ lorsque $W_0$ est au niveau bas 0 logique. Lorsque $W_0$ est au niveau haut 1 logique, $W_1$ à $W_4$ sont au niveau bas 0 logique, les transistors 3 de chaque bascule sont bloqués, donc les entrées $D_1$ à $D_4$ (première grille de chaque transistor 3) sont isolées, et les signaux d'horloge sont transmis aux bascules par $T_0$ à travers la porte N ET-NON.

Le signal de sortie S du circuit programmable est prélevé sur un inverseur $I_5$ monté en sortie de la dernière bascule.

Le fonctionnement de ce circuit programmable applique la règle de permutation pas à pas, et le résultat dépend du programme choisi. En voici quelques exemples:

Programme 1

| | Pas | $O_1$ | $O_2$ | $O_3$ | $O_4$ | S |
|---|---|---|---|---|---|---|
| $W_0=0$ | 1 | 0 | 0 | 0 | 0 | 1 |
| $W_0=1$ | 2 | 0 | 0 | 0 | 0 | 1 |

Durant le premier pas d'horloge, $W_0=0$, donc $W_n=1$ on peut inscrire le programme de la première ligne par les entrées $D_1$ à $D_4$ de façon à avoir, dans ce cas, toutes les sorties $O_1$ à $O_4$ au niveau bas 0 logique. Au cours du second pas d'horloge, $W_0=1$, $W_n=0$, toutes les entrées D sont inhibées: ce programme correspond à une remise à 1.

Programme 2
Comme précédemment, le programme est imposé au cours du premier pas, lorsque $W_0=0$

| | Pas | $O_1$ | $O_2$ | $O_3$ | $O_4$ | S |
|---|---|---|---|---|---|---|
| $W_0=0$ | 1 | 1 | 1 | 1 | 0 | 1 |
| $W_0=1$ | 2 | 0 | 1 | 1 | 1 | 0 |
| $W_0=1$ | 3 | 1 | 0 | 1 | 1 | 0 |
| $W_0=1$ | 4 | 1 | 1 | 0 | 1 | 0 |
| | 5 | 1 | 1 | 1 | 0 | 1 |

Les flèches mettent en évidence la permutation, à chaque pas. Le cinquième pas est identique au premier pas, et ramène au programme initial.

Ce programme transforme le circuit programmable en générateur d'impulsions de niveau haut, dont la période est égale à 4 pas d'horloge.

Programme 3

| | Pas | $O_1$ | $O_2$ | $O_3$ | $O_4$ | S |
|---|---|---|---|---|---|---|
| $W_o=0$ | 1 | 1 | 0 | 0 | 0 | 1 |
| $W_o=1$ | 2 | 0 | 1 | 0 | 0 | 1 |
| $W_o=1$ | 3 | 0 | 0 | 1 | 0 | 1 |
| $W_o=1$ | 4 | 0 | 0 | 0 | 1 | 0 |
| | 5 | 1 | 0 | 0 | 0 | 1 |

Ce programme est l'inverse du précédent. Le circuit programmable est un générateur d'impulsions de niveau bas, de période égale à 4 pas d'horloge.

Programme 4

| | Pas | $O_1$ | $O_2$ | $O_3$ | $O_4$ | S |
|---|---|---|---|---|---|---|
| $W_o=0$ | 1 | 1 | 1 | 0 | 0 | 1 |
| $W_o=1$ | 2 | 0 | 1 | 1 | 0 | 1 |
| $W_o=1$ | 3 | 0 | 0 | 1 | 1 | 0 |
| $W_o=1$ | 4 | 1 | 0 | 0 | 1 | 0 |
| | 5 | 1 | 1 | 0 | 0 | 1 |

Comme dans les précédents programmes, le cinquième pas ramène au programme initial.

Le circuit programmable est un diviseur de fréquence par 4, qui donne des signaux en créneaux de durée 2 pas d'horloge.

Programme 5

| | Pas | $O_1$ | $O_2$ | $O_3$ | $O_4$ | S |
|---|---|---|---|---|---|---|
| $W_o=0$ | 1 | 1 | 0 | 1 | 0 | 1 |
| $W_o=1$ | 2 | 0 | 1 | 0 | 1 | 0 |
| | 3 | 1 | 0 | 1 | 0 | 1 |

Ce programme ne dure que 2 pas: le circuit programmable est un diviseur de fréquence par 2.

D'autres programmes peuvent être écrits: pour un circuit programmable associant 4 bascules B, le nombre de programmes possibles est égal à 16, mais tous ne donnent pas une fonction intéressante par son utilisation.

Ces exemples illustrent l'intérêt des bascules dynamiques en circuits logiques séquentiels. Selon le mode d'écriture choisi, on peut par exemple inscrire les données en parallèle dans une chaine de registres à décalage, et les stocker en les faisant circuler, ce qui constitue une mémoire circulante, ou une ligne à retard.

L'un des avantages de ces bascules est de fonctionner en synchrone, c'est-à-dire avec les mêmes signaux d'horloge, ce qui assure une performance maximale en stabilité et en rapidité.

Un autre avantage réside dans la simplicité du point mémoire qui n'est rien de plus qu'un unique transistor à effet de champ bigrille, normalement bloqué, ainsi qu'en la simplicité des circuits qui lui sont associés, inverseurs DCFL à un seul transistor normalement bloqué.

Enfin, l'utilisation de transistors de type TEGFET, réalisés en matériaux du groupe III-V tels que GaAs et AlGaAs, permet de fabriquer des circuits extrémements rapides, dont des diviseurs de fréquence, en circuits intégrés, fonctionnant jusque 15 GHz.

**Revendications**

1. Elément de mémoire dynamique caractérisé en ce qu'il est constitué par un transistor à effet de champ (1) de type normalement bloqué à tension de seuil positive, dont:
   – la source (10) est reliée à la masse,
   – le drain (11), isolé, constitue la sortie du point mémoire relié à une charge capacitive C,
   – la première grille (12), de type Schottky et voisine de la source (10) du transistor (1), constitue l'entrée de l'élément de mémoire, ou entrée d'écriture,
   – la deuxième grille (13), de type Schottky et voisine du drain (11) du transistor (1), est reliée à une horloge (H), dont le signal logique, 0 ou 1, commande le fonctionnement du transistor (1) et simultanément sert d'alimentation à cet élément de mémoire.

2. Element de mémoire dynamique selon la revendication 1, caractérisé en ce qu'il fonctionne en bascule dynamique, dont le signal d'entrée (12) est inversé sur la sortie (11) lorsque le signal d'horloge (H=13) est un 1 logique, et mis en mémoire lorsque le signal d'horloge est un 0 logique.

3. Bascule maitre-esclave basée sur l'élément de mémoire dynamique selon la revendication 1, caractérisée en ce qu'elle comporte:
   – une bascule maitre formée par au moins un premier transistor à effet de champ (2) dans lequel la source (20) est à la masse, le drain (21) constitue la sortie, la première grille (22) voisine de la source (20) constitue l'entrée d'écriture et la deuxième grille (23), voisine du drain (21) est reliée à une horloge ($H_1$),
   – une bascule esclave formée par un transistor à effet de champ (4) dans lequel la source (26) est à la masse, le drain (27) constitue la sortie de la bascule maitre-esclave, la première grille (28), voisine de la source (26) est reliée à la sortie (21) de la bascule maitre, et la deuxième grille (29), voisine du drain (27) est reliée à une horloge ($H_2$),
   – les signaux logiques 0 et 1 des horloges $H_1$ et $H_2$ étant de plus en opposition de phase.

4. Bascule maitre-esclave selon la revendication 3, caractérisée en ce que, pour le fonctionnement en entrées parallèles/sorties séries, elle comporte en outre, monté en parallèle avec le premier transistor (2), dans la bascule maitre, un second transistor à effet de champ (3) dont la première grille (24), voisine de la source (20), constitue une seconde entrée d'écriture et dont la deuxième grille (25), voisine du drain (21) constitue l'entrée de sélection du mode d'écriture (entrées parallèles ou entrées séries).

5. Diviseur de fréquence par 2, basé sur la bascule maitre-esclave selon la revendication 4, caractérisé en ce qu'il comporte une boucle de réaction, incluant un inverseur ($I_1$), entre la sortie (27) et l'entrée d'écriture (22) de la bascule maitre-esclave, et en ce que le signal de sortie (S) est prélevé après un inverseur ($I_2$) connecté sur la sortie (21) de la bascule maitre.

6. Circuit séquentiel programmable, basé sur la bascule maitre-esclave selon la revendication 4, caractérisé en ce qu'il comporte une pluralité de bascules maitre-esclave montées en série, pour lesquelles:
— la sortie ($O_1$) d'une bascule ($B_1$) est reliée à l'entrée ($E_2$) de la bascule suivante ($B_2$), la sortie ($O_4$) de la dernière bascule ($B_4$) étant bouclée avec l'entrée ($E_1$) de la première bascule ($B_1$),
— les entrées d'horloge ($H_0$) de chaque bascule sont en phase et pilotées par une horloge-mère ($T_o$),
— les entrées de sélection de mode d'écriture (W) sont commandées, à travers un inverseur (I) par un signal ($W_0$) de sélection d'écriture,
— une porte ET-NON, dont une entrée est reliée à l'horloge mère ($T_o$) et dont l'autre entrée est reliée au signal de sélection d'écriture ($W_0$) inhibe l'horloge mère ($T_o$) pendant l'écriture,
— les entrées d'écriture (D) des seconds transistors de chaque bascule maitre servent à inscrire le programme de ce circuit séquentiel programmable, dont la sortie (S) est prélevée après un inverseur ($I_5$) relié à la sortie ($O_4$) de la dernière bascule ($B_4$).

7. Circuit séquentiel programmable selon la revendication 6, caractérisé en ce que, selon le programme, il constitue un circuit diviseur de fréquence programmable ou un circuit générateur de signaux programmable.

**Patentansprüche**

1. Dynamisches Speicherelement, dadurch gekennzeichnet, dass es aus einem Feldeffekttransistor (1) vom selbstsperrenden Typ mit positiver Schwellenspannung besteht, wovon:
— die Source (10) mit Masse verbunden ist,
— der isolierte Drain (11) den Ausgang des mit einer kapazitiven Last C verbundenen Speicherpunktes bildet,
— das erste Gate (12), vom Schottky-Typ und der Source (10) des Transistors (1) benachbart, den Eingang des Speicherelementes bzw. den Schreibeingang bildet,
— das zweite Gate (13), vom Schottky-Typ und dem Drain (11) des Transistors (1) benachbart, mit einem Taktgeber (H) verbunden ist, dessen Logiksignal 0 oder 1 die Funktion des Transistors (1) steuert und gleichzeitig als Stromversorgung dieses Speicherelementes dient.

2. Dynamisches Speicherelement nach Anspruch 1, dadurch gekennzeichnet, dass es als dynamische Kippschaltung arbeitet, deren Eingangssignal (12) am Ausgang (11) invertiert wird, wenn das Taktsignal (H=13) eine logische 1 ist, und gespeichert wird, wenn das Taktsignal eine logische 0 ist.

3. Master-Slave-Kippschaltung, die auf dem dynamischen Speicherelement nach Anspruch 1 basiert, dadurch gekennzeichnet, dass sie umfasst:
— eine Master-Kippschaltung, welche aus wenigstens einem ersten Feldeffekttransistor (2) gebildet ist, in welchem die Source (20) mit Masse verbunden ist, der Drain (21) den Ausgang bildet, das erste, der Source (20) benachbarte Gate (22) den Schreibeingang bildet, und das zweite, dem Drain (21) benachbarte Gate (23) mit einem Taktgeber ($H_1$) verbunden ist,
— eine Slave-Kippschaltung, welche aus einem Feldeffekttransistor (4) besteht, in welchem die Source (26) mit Masse verbunden ist, der Drain (27) den Ausgang der Master-Slave-Kippschaltung bildet, das erste Gate (28), das der Source (26) benachbart ist, mit dem Ausgang (21) der Master-Kippschaltung verbunden ist und das zweite Gate (29), das dem Drain (27) benachbart ist, mit einem Taktgeber ($H_2$) verbunden ist,
— wobei die Logiksignale 0 und 1 der Taktgeber $H_1$ und $H_2$ ferner entgegengesetzte Phasen aufweisen.

4. Master-Slave-Kippschaltung nach Anspruch 3, dadurch gekennzeichnet, dass sie für den Betrieb mit parallelen Eingängen/und seriellen Ausgängen ferner einen zweiten Feldeffekttransistor (3) in der Master-Kippschaltung umfasst, welcher zu dem ersten Transistor parallel geschaltet ist und wovon das erste Gate (24), das der Source (20) benachbart ist, einen zweiten Schreibeingang bildet und das zweite Gate (25), das dem Drain (21) benachbart ist, den Eingang zur Auswahl der Schreibweise (parallele Eingänge oder serielle Eingänge) bildet.

5. Frequenzteiler, der durch 2 teilt und auf der Master-Slave-Kippschaltung nach Anspruch 4 basiert, dadurch gekennzeichnet, dass er eine Rückkopplungsschleife umfasst, welche zwischen dem Ausgang (27) und dem Schreibeingang (22) der Master-Slave-Kippschaltung einen Inverter ($I_1$) enthält, und dass das Ausgangssignal (S) hinter einem an dem Ausgang (21) der Master-Slave-Kippschaltung angeschlossenen Inverter ($I_2$) abgenommen wird.

6. Programmierbare sequentielle Schaltung, welche auf der Master-Slave-Kippschaltung nach Anspruch 4 basiert, dadurch gekennzeichnet, dass sie eine Mehrzahl von in Reihe geschalteten Master-Slave-Kippschaltungen umfasst, für welche:
— der Ausgang ($O_1$) einer Kippschaltung ($B_1$) mit dem Eingang ($E_2$) der folgenden Kippschaltung ($B_2$) verbunden ist, wobei der Ausgang ($O_4$) der letzten Kippschaltung ($B_4$) mit dem Eingang ($E_1$) der ersten Kippschaltung ($B_1$) eine Schleife bildet,

– die Taktgebereingänge ($H_0$) jeder Kippschaltung gleichphasig sind und über einen Haupt-Taktgeber ($T_0$) gesteuert sind,

– die Eingänge zur Auswahl der Schreibweise (W) über einen Inverter (I) von einem Schreib-Auswahlsignal ($W_0$) gesteuert sind,

– ein NAND-Gate, wovon ein Eingang mit dem Haupttaktgeber ($T_0$) sowie der andere Eingang mit dem Schreib-Auswahlsignal ($W_0$) verbunden ist, den Haupttaktgeber ($T_0$) während des Einschreibens sperrt,

– die Schreibeingänge (D) der zweiten Transistoren jeder Master-Kippschaltung dazu dienen, das Programm dieser programmierbaren sequentiellen Schaltung einzuschreiben, wovon der Ausgang (S) hinter einem mit dem Ausgang ($O_4$) der letzten Kippschaltung ($B_4$) verbundenen Inverter ($I_5$) abgenommen wird.

7. Programmierbare sequentielle Schaltung nach Anspruch 6, dadurch gekennzeichnet, dass sie je nach Programm entweder eine programmierbare Frequenzteiler-Schaltung oder eine programmierbare Signalgenerator-Schaltung bildet.

## Claims

1. A dynamic memory element characterized in that it is constituted by a field effect transistor (1) of the normally turned off type with a positive threshold voltage of which

– the source (10) is connected with ground,

– the insulated drain (11) constitutes the output of the memory cell connected with a capacitive charge C,

– the first gate (12) of the Schottky type is adjacent to the source (10) of the transistor (1) and constitutes the input of the memory element or the writing input, and

– the second gate (13) of the Schottky type is adjacent to the drain (11) of the transistor (1) and is connected with a clock (H) whose 0 or 1 logical signal controls the operation of the transistor (1) and simultaneously serves for feeding such memory element.

2. The dynamic memory element as claimed in claim 1, characterized in that it functions as a dynamic flipflop whose input signal (12) is inverted at the output (11) when the clock signal (H=13) is a logical 1, and is stored when the clock signal is a logical 0.

3. A slave master flipflop based on the use of the dynamic element as claimed in claim 1, characterized in that it comprises:

– a master flipflop formed by at least one field effect transistor (2) in which the source (20) is grounded, the drain (21) constitutes the output, the first gate (22) adjacent to the source (20) constitutes a write input and the second gate (23), adjacent to the drain (21), is connected with a clock ($H_1$),

– a slave flipflop formed by a field effect transistor (4) whose source (26) is grounded, the drain (27) constitutes the output of the slave master flipflop, the first gate (28), adjacent to the source (26), is connected with the output (21) of the master flipflop, and the second gate (29), adjacent to the drain (27), is connected to a clock ($H_2$), and

– the 0 and 1 logical signals of the clocks $H_1$ and $H_2$ are oppositely phased.

4. The slave master flipflop as claimed in claim 3, characterized in that, for operation with inputs in parallel and outputs in series, it furthermore comprises, connected in parallel with the first transistor (2), in the master flipflop, a second field effect transistor (3), whose first gate (24) adjacent to the source (20) constitutes a second write input and whose second gate (25), adjacent to the drain (21), constitutes the selection input of the write mode (inputs in parallel or inputs in series).

5. A factor of 2 frequency divider, based on the slave master flipflop as claimed in claim 4, characterized in that it comprises a reaction loop including an inverter ($I_1$), placed between the output (27) and the write input (22) of the slave master flipflop, and in that the output signal (S) is taken on the output side of an inverter ($I_2$) connected with the output (21) of the master flipflop.

6. A programmable sequential circuit, based on the use of the slave master flipflop as claimed in claim 4, characterized in that it comprises a plurality of slave master flipflops connected in series, in respect of which:

– the output ($O_1$) of one flipflop ($B_1$) is connected with the input ($E_2$) of the following flipflop ($B_2$), the output ($O_4$) of the last flipflop ($B_4$) being connected with the input ($E_1$) of the first flipflop ($B_1$),

– the clock inputs ($H_0$) of each flipflop are in phase and are piloted by a mother clock ($T_0$),

– the write mode selection inputs (W) are controlled, through an inverter (I), by a write selection signal ($W_0$),

– an AND-NO gate of which one input is connected with the mother clock ($T_0$) and whose other input is connected with the write select signal ($W_0$) inhibits the mother clock ($T_0$) during writing, and

– the write inputs (D) of the second transistors of each master flipflop serve for writing the program of this programmable sequential circuit, whose output (S) is taken on the output side of an inverter ($I_5$) connected with the output ($O_4$) of the last flipflop ($B_4$).

7. The programmable sequential circuit as claimed in claim 6, characterized in that, in accordance with the program, it constitutes a programmable frequency divider circuit or a programmable signal generator circuit.

# FIG_1

# FIG_2

# FIG_3

FIG_4

FIG_5

EP 0 186 533 B1